# EUROPÄISCHE PATENTSCHRIFT

(11) **EP 3 425 346 B1**
(45) Veröffentlichungstag und Bekanntmachung des Hinweises auf die Patenterteilung: **10.11.2021**
(21) Anmeldenummer: 18176501.7
(22) Anmeldetag: 07.06.2018
(51) Int. Cl.: G01D 21/00

(54) **MESSGERÄT, TRANSMITTERGEHÄUSE UND VERFAHREN ZUR HERSTELLUNG EINES MESSGERÄTS**
MEASURING ELEMENT, TRANSMITTER HOUSING AND METHOD FOR MANUFACTURING A MEASURING ELEMENT
APPAREIL DE MESURE, BOÎTIER ÉMETTEUR ET PROCÉDÉ DE FABRICATION D'UN APPAREIL DE MESURE

(30) Priorität: 07.07.2017 DE 102017115259
(43) Veröffentlichungstag der Anmeldung: 09.01.2019
(73) Patentinhaber: Krohne Messtechnik GmbH, 47058 Duisburg (DE)
(72) Erfinder: Erkelenz, Alexander, 47447 Moers (DE); Matt, Achim, 47055 Duisburg (DE)
(74) Vertreter: Gesthuysen Patentanwälte

(56) Entgegenhaltungen:
- EP-A1- 1 130 363
- DE-A1-102012 005 637
- JP-A- 2011 146 436
- US-A1- 2016 093 997

## Beschreibung

Die Erfindung geht aus von einem Messgerät mit wenigstens einem Sensor und mit wenigstens einem Transmittergehäuse, wobei das Transmittergehäuse wenigstens einen Klemmenraum und einen zum Klemmenraum benachbarten und über eine Trennwand verbundenen Elektronikraum aufweist, wobei in dem Klemmenraum wenigstens eine erste Elektronikeinrichtung für den Anschluss von Versorgungs- und/oder I/O-Leitungen angeordnet ist und wobei in dem Elektronikraum wenigstens eine zweite Elektronikeinrichtung mit Elektronik zur Steuerung des Sensors angeordnet ist, wobei die erste Elektronikeinrichtung und die zweite Elektronikeinrichtung über eine Kontaktierungseinheit miteinander elektrisch leitend verbunden sind und wobei die Kontaktierungseinheit lösbar in eine Ausnehmung der Trennwand eingesetzt ist.

Darüber hinaus betrifft die Erfindung ein Transmittergehäuse und ein Verfahren zur Herstellung eines Messgeräts, wobei das Messgerät wenigstens einen Sensor und wenigstens ein Transmittergehäuse aufweist, wobei das Transmittergehäuse wenigstens einen Klemmenraum und einen zum Klemmenraum benachbarten und über eine Trennwand verbundenen Elektronikraum aufweist, wobei in dem Klemmenraum eine erste Elektronikeinrichtung für den Anschluss von Versorgungs- und/oder I/O-Leitungen angeordnet ist und wobei in dem Elektronikraum eine zweite Elektronikeinrichtung mit Elektronik zur Steuerung des Sensors angeordnet ist, wobei die in dem Elektronikraum angeordnete zweite Elektronikeinrichtung eine Anschlusseinheit aufweist, wobei eine Kontaktierungseinheit vorhanden ist, die mit der ersten Elektronikeinrichtung fest verbunden ist, wobei die Kontaktierungseinheit Kontaktelemente in Form von Netzanschlusselementen und/oder Signalkontaktelementen zur Übertragung elektrischer Signale aufweist und wobei die Anschlusseinheit Verbindungselemente in Form von Netzverbindungselementen und/oder Signalverbindungselementen aufweist.

Aus dem Stand der Technik sind Messgeräte bekannt, die neben einer Sensoreinheit zur Aufnahme von physikalischen oder chemischen Messgrößen eine modulare Elektronikeinheit zur Steuerung und zur Versorgung der Sensoreinheit sowie zur Weiterleitung und/oder Auswertung der aufgenommenen Messdaten aufweisen. Üblicherweise ist die Elektronikeinheit in einem Gehäuse angeordnet. Dabei werden in Abhängigkeit vom Einsatzgebiet des Messgeräts, insbesondere der Art der Explosionsgefährdung, unterschiedliche Anforderungen an das Gehäuse und/oder an die Ausgestaltung der Elektronikeinheit gestellt, um die Entstehung und/oder die Ausbreitung einer Explosion zu verhindern.

Folgende Zündschutzarten für elektrische Geräte sind im Rahmen der Erfindung relevant:
"Ex-e" bezeichnet die Anforderung an die Konstruktion von Betriebsmitteln, die einer erhöhten Sicherheit unterliegen. Es werden Maßnahme getroffen, um das Entstehen von Funken in inneren oder äußeren Teilen elektrischer Bauteile zu verhindern. Solche Maßnahmen sind beispielsweise das Überdimensionieren von kritischen Stellen, eine verstärkte Betriebs- und Basisisolation, ein Überlastschutz, ein sicherer Anschluss von ankommenden Leitungen und/oder ein ausreichend mechanischer Schutz.

"Ex-i" bezeichnet die Anforderungen an die Eigensicherheit von Stromkreisen bzw. die Begrenzung der Energie in Stromkreisen. Dies beinhaltet insbesondere, dass ein eigensicherer Stromkreis mit einem ausreichendem Abstand von anderen Stromkreisen getrennt ist. Dabei entspricht der Abstand zwischen zwei Stromkreisen dem kürzesten Weg zwischen diesen Stromkreisen. Unterschieden wird grundsätzlich nach Art des Mediums, durch das der Weg des kürzesten Abstandes führt, so dass sich unterschiedliche Mindestabstände für Luftstrecken, Strecken im Verguss, Abstände durch feste Isolierung, Kriechstrecken in Luft oder Kriechstrecken unter Schutzschicht ergeben.

Zur Bestimmung der einzuhaltenen Mindestabstände wird auf die Normen IEC 60664-1:2007, IEC 61010-1:2010 und IEC 60079-11:2011 verwiesen, deren Inhalt ausdrücklich in die vorliegende Anmeldung einbezogen wird.

"Ex-d" bezeichnet die Anforderung an die Ausgestaltung eines Gehäuse als druckfeste Kapselung, wobei unter dieser Zündschutzart Explosionen im Inneren des Gehäuses zugelassen werden, ihre Auswirkungen auf die Umwelt jedoch durch eine druckfeste Ausgestaltung des Gehäuses verhindert werden sollen.

Im Rahmen der vorliegenden Erfindung wird unterschieden nach Ausgestaltungen, die die Anforderungen zur Gewährleistung eines explosionssicheren Messgeräts erfüllen, und weiterhin nach Ausgestaltungen, die für den Einsatz in einer nicht-explosionsgefährdeten Umgebung geeignet sind.

Eine modulare Elektronikeinheit zur Steuerung und zur Versorgung der Sensoreinheit sowie zur Weiterleitung und/oder Auswertung der aufgenommenen Messdaten umfasst im Rahmen der vorliegenden Erfindung sowohl die Elektronik zum Betreiben des Sensors als auch Anschlüsse für Versorgungs- und I/O - Leitungen, also Input/Output - Leitungen. Üblicherweise sind diese beiden Einheiten in voneinander getrennten Kammern angeordnet.

Im Detail ist die Elektronik zum Betreiben des Sensors in einem Elektronikraum angeordnet. Der Elektronikraum kann weiterhin eine Verbindung zur Sensoreinheit des Messgeräts aufweisen.

Die Anschlüsse für Versorgungs- und I/O-Leitungen sind in einem Klemmenraum angeordnet. Durch die Trennung der beiden Räume kann insbesondere verhindert werden, dass im Elektronikraum entstehende Explosionen sich ungehindert in den Klemmenraum ausbreiten können.

Die im Elektronikraum angeordnete zweite Elektronikeinrichtung und die im Klemmenraum angeordnete erste Elektronikeinrichtung sind in aus dem Stand der Technik bekannten Messgeräten mittels einer Kontaktierungseinheit miteinander verbunden, wobei über die Kontakierungseinheit sowohl Strom als auch elektrische Signale, in Form von Spannungen übertragen werden.

Aus dem Stand der Technik der DE 203 14 618 U1 ist beispielsweise ein Messgerät mit einem Gehäuse bekannt, wobei das Gehäuse zwei Kammern aufweist, die über einen Durchführungsraum miteinander verbunden sind, wobei der Durchführungsraum mit einer Vergussmasse vergossen ist. Zur Übertragung von Strom und elektrischen Signalen ist eine Stiftleiste vorhanden, die mittels einer Schraube mit dem Gehäuse verbunden ist.

Die Druckschrift DE 10 2012 005 637 A1 offenbart ein Messgerät mit einem Gehäuse, wobei das Gehäuse zwei Kammer aufweist und wobei die beiden Kammern über ein verkapseltes Kontaktierungselement miteinander verbunden sind. Da das Kontaktierungselement an sich bereits verkapselt ist und es insofern einer Verkapselung im Gehäuse nicht mehr Bedarf, lassen sich defekte Bauteile besonders einfach austauschen, da lediglich Steckverbindungen zu lösen sind.

Das Dokument JP 2011 146436 A offenbart ein Messgerät mit einer Einheit aus einem ersten und einem zweiten Elektronikeinsatz, wobei die Elektronikeinsätze über eine Kontaktierungseinheit miteinander verbunden sind. Diese Einheit kann derart in einer Trennwand in einem Transmitter derart montiert werden, dass die Elektronikeinsätze in unterschiedlichen Kammern angeordnet sind.

Ausgehend von diesem Stand der Technik liegt der vorliegenden Erfindung die Aufgabe zu Grunde, ein Transmittergehäuse und ein Messgerät anzugeben, das einfach herzustellen ist und dessen Komponenten sich besonders leicht austauschen lassen. Darüber hinaus liegt der Erfindung die Aufgabe zu Grunde, ein Verfahren zur Herstellung eines solchen Messgeräts anzugeben.

Gemäß einer ersten Lehre der vorliegenden Erfindung wird die zuvor genannte Aufgabe durch ein eingangs genanntes Messgerät dadurch gelöst, dass die Kontaktierungseinheit mit der ersten Elektronikeinrichtung fest verbunden ist, dass die Kontaktierungseinheit Kontaktelemente in Form von Netzanschlusselementen und/oder Signalkontaktelementen zur Übertragung elektrischer Signale aufweist
dass die in dem Elektronikraum angeordnete zweite Elektronikeinrichtung eine Anschlusseinheit aufweist,
dass die Anschlusseinheit Verbindungselemente in Form von Netzverbindungselementen und/oder Signalverbindungselementen aufweist, wobei die Verbindungselemente mit den Kontaktelementen elektrisch leitend mittels einer Steckverbindung verbunden sind.

Erfindungsgemäß wurde erkannt, dass wenn die Kontaktierungseinheit fest mit der ersten Elektronikeinrichtung verbunden ist, diese beiden Komponenten als Baugruppe einerseits besonders einfach zu montieren und andererseits besonders leicht auszutauschen sind, wodurch das Messgerät insgesamt eine besonders hohe Modularität aufweist. Dabei wird im Rahmen der vorliegenden Erfindung unter einer festen Verbindung eine lösbare oder unlösbare Verbindung verstanden, sodass die Kontaktierungseinheit und die Elektronikeinrichtung als ein Bauteil handhabbar sind. Beispielsweise kann eine feste Verbindung eine Klebeverbindung, eine Verbindung mittels Löten oder eine Rastverbindung sein. Besonders bevorzugt ist die Verbindung als starre Verbindung ausgestaltet, wobei die Kontaktierungseinheit ebenfalls als starres, nicht flexibles Bauteil ausgestaltet ist.

Gemäß einer bevorzugten Ausgestaltung ist die erste Elektronikeinrichtung lösbar über wenigstens ein Befestigungsmittel mit dem Transmittergehäuse verbunden. Beispielsweise ist die erste Elektronikeinrichtung mit dem Transmittergehäuse verschraubt. Vorzugsweise ist wenigstens eine Schraube oder ein anderes Befestigungsmittel oder wenigstens zwei Schrauben oder zwei andere Befestigungsmittel unmittelbar neben der Kontaktierungseinheit angeordnet, um die Kontaktierungseinheit stabilisierend zu halten. Dabei liegen die Schrauben bzw. die anderen Befestigungsmittel unmittelbar an der Kontaktierungseinheit an und/oder berühren die Kontaktierungseinheit. Darüber hinaus ist vorzugsweise wenigstens eine Verbindung zwischen der ersten Elektronikeinrichtung und dem Transmittergehäuse als sichere Verbindung zum Gehäuse ausgestaltet. Dazu ist vorzugsweise die erste Elektronikeinrichtung, insbesondere das Massepotential der ersten Elektronikeinrichtung, elektrisch leitend mit dem Transmittergehäuse verbunden.

Gemäß einer vorteilhaften Ausgestaltung umfasst die erste Elektronikeinrichtung eine erste Leiterplatte und/oder die zweite Elektronikeinrichtung umfasst eine zweite Leiterplatte.

Besonders bevorzugt ist die Form der ersten Elektronikeinrichtung zumindest teilweise an die innere Form des Klemmenraums und/oder die Form der zweiten Elektronikeinrichtung ist zumindest teilweise an die innere Form des Elektronikraums angepasst. Weist das Transmittergehäuse zumindest im Bereich des Klemmenraums und/oder des Elektronikraums einen kreisförmigen Querschnitt auf, so weist bzw. weisen vorzugsweise auch die erste und/oder die zweite Elektronikeinrichtung die Form eines Kreises oder eines Kreisabschnittes, insbesondere eines Halbkreises auf.

Zudem weist die erste Elektronikeinrichtung vorzugsweise wenigstens ein Anschlusselement, zur Kontaktierung des Netzanschlusses und wenigstens ein Anschlusselement zur Kontaktierung der Signalübertragungselemente auf. Die zuvor genannten Anschlusselemente sind vorzugsweise als Klemmen ausgestaltet.

Gemäß einer weiteren Ausgestaltung sind die erste Elektronikeinrichtung und der Klemmenraum derart ausgestaltet, dass die im Betrieb des Messgeräts zu den Anschlusselementen laufenden Verbindungskabel im Klemmenraum durch ausreichend Platz mechanisch stabilisiert werden können.

Gemäß einer weiteren vorteilhaften Ausgestaltung ist bzw. sind die erste Elektronikeinrichtung und/oder die Anschlusselemente beispielsweise in Form von Klemmen mit einem Isolierstoff bedeckt. Damit kann gewährleistet werden, dass auch wenn der Anwender den Klemmenraum öffnet, ein ausreichender Schutz zu den elektronischen Anschlüssen besteht.

Gemäß einer weiteren vorteilhaften Ausgestaltung ist die Kontaktierungseinheit als elektrisches Durchführungselement ausgestaltet, vorzugsweise als Stopfen mit eingeglasten oder in Kunststoff eingegossenen Kontaktelementen, insbesondere wobei der Stopfen in einen Metallzylinder eingefasst ist.

Ein Glas/Metall-Durchführungselement ist in vorteilhafter Weise geeignet für den Einsatz in explosionsgefährdeter Umgebung. Ein Durchführungselement aus Kunststoff ist geeignet für den Einsatz in nicht explosionsgefährderter Umgebung.

Gemäß der Erfindung weist die Kontaktierungseinheit die Kontaktelemente in Form von Netzanschlusselementen und/oder Signalkontaktelementen zur Übertragung elektrischer Signale auf. Die Kontaktelemente können als Stifte oder auch als Buchsen ausgestaltet sein. Die Kontaktelemente sind vorzugsweise paarweise angeordnet.

Gemäß einer Ausgestaltung weisen die Netzanschlusselemente im Vergleich zu den Signalkontaktelementen einen größeren Querschnitt auf.

Vorteilhaft ist es, wenn die Netzanschlusselemente und/oder die Signalkontaktelemente zumindest teilweise stoffschlüssig mit der ersten Elektronikeinrichtung verbunden sind. Beispielsweise können die Kontaktelemente mit der ersten Elektronikeinrichtung verlötet sein.

Vorteilhaft ist es weiterhin, wenn die Kontaktelemente innerhalb eines Schutzkragens angeordnet sind, wodurch die Zündschutzsicherheit des Messgeräts erhöht werden kann.

Weiterhin ist es vorteilhaft, wenn die erste Elektronikeinrichtung mit den Kontaktelementen der Kontaktierungseinheit fest verbunden ist und wenn die erste Elektronikeinrichtung zwischen den Netzanschlusselementen und den Signalkontaktelementen und/oder zwischen den Signalkontaktelementen untereinander Mittel zur Vergrößerung des Abstandes, im Detail zur Vergrößerung der Kriechstrecken, beispielsweise wenigstens eine Bohrung und/oder wenigstens einen Schlitz aufweist. Dabei ist die Bohrung und/oder der wenigstens eine Schlitz vorzugsweise mittels Fräsen in die erste Elektronikeinrichtung eingebracht. Die wenigstens eine Bohrung kann kreisförmig ausgestaltet sein und/oder jede andere an die Anwendung angepasste Geometrie aufweisen. Zudem kann der wenigstens eine Schlitz gebogen oder gerade ausgestaltet sein und insbesondere jede an die Anwendung angepasste Geometrie aufweisen. Insbesondere kann auch wenigstens ein Kontaktelement vollständig von einer Ausnehmung umschlossen sein.

Gemäß dieser Ausgestaltung können die zur Gewährleistung eines explosionsgeschützten Bauteils geforderten Trennabstände zwischen den einzelnen Kontaktelementen auch auf engem Raum gewährleistet werden.

Gemäß einer weiteren vorteilhaften Ausgestaltung sind die Signalkontaktelemente kreisförmig in wenigstens einem Kreis um wenigstens ein Netzanschlusselement angeordnet. Durch die kreisförmige Anordnung ist gemäß einer bevorzugten Ausgestaltung gewährleistet, dass bei entsprechend gewähltem Radius des Kreises sämtliche Signalkontaktelemente den erforderlichen Mindestabstand zu dem wenigstens einen Netzanschlusselement zur Gewährleistung einer Explosionssicherheit, einhalten.

Daneben ist es ebenfalls denkbar und vorteilhaft, wenn die Signalverbindungselemente in einer anderen geometrischen Form um wenigstens ein Netzverbindungselement angeordnet sind.

Gemäß einer Ausgestaltung sind die Signaverbindungselemente derart, vorzugsweise kreisförmig, um das wenigstens eine Netzverbindungselement angeordnet, dass der Abstand zwischen dem wenigstens einen Netzverbindungselement und den Signalverbindungselementen mindestens dem normierten Mindestabstand zur Einhaltung der Luft- und Kriechfestigkeit entspricht.

Besonders bevorzugt sind die Signalkontaktelemente in wenigstens zwei Kreisen mit unterschiedlichem Radius bzw. Abstand zu dem wenigstens einen Netzanschlusselement angeordnet. Dabei weisen vorzugsweise sämtliche Signalkontaktelemente den erforderlichen Mindestabstand zur Gewährleistung einer Explosionssicherheit zu den Netzanschlusselementen auf. Beispielsweise kann weiterhin vorgesehen sein, dass wenigstens ein Abstand zwischen wenigstens einem Signalkontaktelement und einem Netzanschlusselement und/oder wenigstens ein Abstand zwischen zwei Signalkontaktelementen und/oder wenigstens ein Abstand zwischen den Netzanschlusselementen den erforderlichen Mindestabstand zur Gewährleistung des Explosionsschutzes unterschreitet. Zwar kann eine solche Ausgestaltung nur in einer nicht explosionsgefährdeten Umgebung eingesetzt werden, jedoch weist diese Ausgestaltung den Vorteil auf, dass besonders viele Kontaktelemente auf begrenztem Raum zur Signalübertragung zur Verfügung stehen. Beispielsweise können so auch Gigabit-Ethernet-Verbindungen auf engem Raum realisiert werden.

Gemäß einer Ausgestaltung weist die Kontaktierungseinheit wenigstens 15 Kontaktelemente auf. Gemäß einer nächsten Ausgestaltung weist die Kontaktierungseinheit wenigstens 22 Kontaktelemente auf.

Gemäß einer nächsten vorteilhaften Ausgestaltung sind die Signalkontaktelemente zu wenigstens einer Schaltkreisgruppe zusammengefasst, wobei die wenigstens eine Schaltkreisgruppe wenigstens zwei Signalkontaktelemente aufweist. Besonders bevorzugt sind wenigstens zwei räumlich voneinander getrennte Schaltkreisgruppen vorhanden. Dabei entspricht der Abstand zwischen den Schaltkreisgruppen, also der geringste Abstand zwischen den Signalkontaktelementen der unterschiedlichen Schaltkreise, wenigstens dem normierten Mindestabstand zur Gewährleistung einer Explosionssicherheit. Gemäß einer weiteren Ausgestaltung ist die Kontaktierungseinheit derart ausgestaltet, dass innerhalb wenigstens einer Schaltkreisgruppe oder zwischen wenigstens zwei Schaltkreisgruppen wenigstens ein Abstand zwischen zwei Signalkontaktelementen den normierten Mindestabstand zur Einhaltung der Luft- und/oder Kriechfestigkeit unterschreitet. Diese Ausgestaltung ist nur für den Einsatz in nicht-explosionsgefährdeter Umgebung geeignet, weist aber den Vorteil auf, dass auf besonders engem Raum viele Kontaktelemente zur Verfügung gestellt werden können.

Erfindungsgemäß weist die in dem Elektronikraum angeordnete zweite Elektronikeinrichtung eine Anschlusseinheit auf, die mit der Kontaktierungseinheit elektrisch leitend verbunden ist. Besonders bevorzugt ist die Anschlusseinheit mit einem Isolierstoff bedeckt.

Erfindungsgemäß weist die Anschlusseinheit Verbindungselemente in Form von Netzverbindungselementen und/oder Signalverbindungselementen auf, wobei die Verbindungselemente mit den Kontaktelementen elektrisch leitend mittels einer Steckverbindung verbunden sind. Vorzugsweise weist die Steckverbindung eine Fügerichtung auf, wobei die Anschlusseinheit in Fügerichtung fest angeordnet ist und wobei die Anschlusseinheit senkrecht zur Fügerichtung derart schwimmend angeordnet ist, dass sie sich bei der Verbindung mit der Kontaktierungseinheit an die Position der Kontaktierungseinheit anpasst.

Gemäß dieser Ausgestaltung ist die Verbindung zwischen der Anschlusseinheit und der Kontaktierungseinheit selbstzentrierend ausgestaltet. Beispielsweise ist die Anschlusseinheit schwimmend in einer Halterung angeordnet. Diese Ausgestaltung weist den Vorteil auf, dass die Anschlusseinheit besonders einfach und flexibel mit der Kontaktierungseinheit während der Montage des Messgeräts verbunden werden kann.

Eine selbstzentrierende Verbindung kann beispielsweise dadurch realisiert werden, dass die Verbindungselemente und/oder die Kontaktelemente als trichterförmige Aufnahmen ausgestaltet. Besonders bevorzugt weisen die trichterförmigen Aufnahmen einen ausreichenden Toleranzbereich, vorzugsweise zwischen 0,2 und 0,5 mm, besonders bevorzugt zwischen 0,2 und 0,3 mm auf.

Gemäß einer Ausgestaltung weist die Öffnung der trichterförmigen Aufnahmen einen Durchmesser zwischen 0,2 und 0,5 mm und besonders bevorzugt zwischen 0,2 und 0,3 mm auf, wobei sich der Hals der trichterförmigen Aufnahmen zumindest abschnittsweise verjüngt.

Gemäß einer weiteren bevorzugten Ausgestaltung weist die zweite Elektronikeinrichtung eine zumindest teilweise biegbare Leiterplatte auf. Beispielsweise kann die Leiterplatte Flex-Leiterplatte oder als starrflexe Leiterplatte oder als semiflexe Leiterplatte oder als Twinflex-Leiterplatte ausgestaltet sein. Besonders bevorzugt weist die Leiterplatte wenigstens zwei starre Leiterplattenteile und wenigstens einen biegbaren Teil auf. Besonders bevorzugt ist die Anschlusseinheit als ein starrer Teil der biegbaren Leiterplatte ausgestaltet. Weiterhin ist es vorteilhaft, wenn die wenigstens zwei starren Teile der biegbaren Leiterplatte einen Winkel, vorzugsweise einen Winkel zwischen 90° und 180° oder zwischen 90° und 160°oder einen 90°-Winkel oder einen Winkel zwischen 45° und 90° einschließen. Insgesamt kann das Transmittergehäuse damit besonders kompakt ausgestaltet sein.

Gemäß einer weiteren besonders bevorzugten Ausgestaltung umfasst die biegbare Leiterplatte innenliegende Leiterbahnen. An die Abstände zwischen innenliegenden Leiterbahnen werden zur Gewährleistung eines Explosionsschutzes geringere Anforderungen gestellt. Insofern kann ein explosionssicheres Messgerät bereitgestellt werden, das gleichzeitig eine hohe Anzahl an Signalübertragungselementen auf engem Raum bereitstellt.

Die im Elektronikraum angeordnete Elektronik zur Steuerung des Sensors ist vorzugsweise als kompakter Geräteeinsatz, ausgestaltet, der über Steckverbindung mit der zweiten Elektronikeinrichtung verbunden ist. Ein kompakter Geräteinsatz kann beispielsweise übereinander gestapelte, bestückte Leiterplatten umfassen, die mittels einer Steckverbindung mit der zweiten Elektronikeinrichtung verbunden sind. Diese Ausgestaltung weist den Vorteil auf, dass die gesamte Elektronik als Baugruppe besonders leicht austauschbar ist.

Gemäß einer weiteren Ausgestaltung ist die zweite Elektronikeinrichtung lösbar, beispielsweise durch eine Schraubverbindung mit dem Transmittergehäuse verbunden. Weiterhin ist vorzugsweise eine sichere Verbindung zwischen der zweiten Elektronikeinrichtung und dem Transmittergehäuse vorhanden. Eine sichere Verbindung wird vorzugsweise durch eine leitende Verbindung des Massepotentials der zweiten Elektronikeinrichtung zum Transmittergehäuse realisiert.

Grundsätzlich kann das Transmittergehäuse derart ausgestaltet sein, dass der Elektronikraum bzw. die im Elektronikraum angeordneten Elemente und der Klemmenraum bzw. die im Klemmenraum angeordneten Elemente die Anforderungen von gleichen Zündschutzklassen oder unterschiedlicher Zündschutzklassen erfüllen.

Beispielsweise können sowohl der Elektronikraum als auch der Klemmenraum die Anforderungen bezüglich des Berührschutzes und der elektromagnetischen Verträglichkeit erfüllen ohne für die Anwendung in explosionsgefährdeter Umgebung geeignet zu sein.

Zudem können sowohl der Elektronikraum als auch der Klemmenraum die Anforderungen bezüglich des Berührschutzes und der elektromagnetischen Verträglichkeit erfüllen, wobei der Elektronikraum zusätzlich druckfest gekapselt ist (Ex-d) und der Klemmenraum die Anforderungen einer erhöhten Sicherheit erfüllt (Ex-e).

Weiterhin können sowohl der Elektronikraum als auch der Klemmenraum die Anforderungen bezüglich des Berührschutzes und der elektromagnetischen Verträglichkeit erfüllen, wobei der Elektronikraum zusätzlich druckfest gekapselt ist (Ex-d) und eine sichere Trennung zwischen Ex-e-Signalen (Netzspannung) und Ex-i-Signalen (I/O-Anschluss) gewährleistet ist. Darüber hinaus können sowohl der Elektronikraum als auch der Klemmenraum die Anforderungen bezüglich des Berührschutzes und der elektromagnetischen Verträglichkeit und zusätzlich einer druckfesten Kapselung (Exd) erfüllen.

Schließlich können sowohl der Elektronikraum als auch der Klemmenraum die Anforderungen bezüglich des Berührschutzes und der elektromagnetischen Verträglichkeit und zusätzlich einer druckfesten Kapselung (Ex-d) erfüllen, wobei die Kontaktierungseinheit nicht druckfest ausgestaltet ist.

Gemäß einer zweiten Lehre der vorliegenden Erfindung wird die eingangs hergeleitete Aufgabe durch ein Transmittergehäuse gelöst, wobei das Transmittergehäuse wenigstens einen Klemmenraum und einen zum Klemmenraum benachbarten und über eine Trennwand verbundenen Elektronikraum aufweist, wobei in dem Klemmenraum wenigstens eine erste Elektronikeinrichtung für den Anschluss von Versorgungs- und/oder I/O-Leitungen angeordnet ist und wobei in dem Elektronikraum wenigstens eine zweite Elektronikeinrichtung mit Elektronik zur Steuerung des Sensors angeordnet ist, wobei die erste Elektronikeinrichtung und die zweite Elektronikeinrichtung über eine Kontaktierungseinheit miteinander elektrisch leitend verbunden sind, wobei die Kontaktierungseinheit lösbar in eine Ausnehmung der Trennwand eingesetzt ist.

Das Transmittergehäuse zeichnet sich dadurch aus, dass die Kontaktierungseinheit mit der ersten Elektronikeinrichtung fest verbunden ist, wobei die Kontaktierungseinheit Kontaktelemente in Form von Netzanschlusselementen und/oder Signalkontaktelementen zur Übertragung elektrischer Signale aufweist,
wobei die in dem Elektronikraum angeordnete zweite Elektronikeinrichtung eine Anschlusseinheit aufweist,
wobei die Anschlusseinheit Verbindungselemente in Form von Netzverbindungselementen und/oder Signalverbindungselementen aufweist, wobei die Verbindungselemente mit den Kontaktelementen elektrisch leitend mittels einer Steckverbindung verbunden sind und dass das Transmittergehäuse für die Verwendung in einem der zuvor beschriebenen Messgeräte ausgestaltet ist.

Gemäß einer nächsten Lehre der vorliegenden Erfindung wird die eingangs hergeleitete Aufgabe durch ein eingangs genanntes Verfahren zur Herstellung eines Messgeräts, dadurch gelöst, dass das Verfahren die folgenden Schritte umfasst:
- Montieren der zweiten Elektronikeinrichtung in dem Elektronikraum, wobei die Anschlusseinheit schwimmend angeordnet wird,
- Montieren der ersten Elektronikeinrichtung in dem Klemmenraum, wobei die Kontaktierungseinheit lösbar in die Trennwand eingesetzt wird,
- wobei durch das Montieren der ersten Elektronikeinrichtung die Kontaktierungseinheit mit der Anschlusseinheit verbunden wird,
- wobei die Anschlusseinheit sich selbstzentrierend an die Position der Kontaktierungseinheit anpasst.

Das erfindungsgemäße Verfahren weist auf Grund der selbstzentrierenden Verbindung zwischen der Anschlusseinheit und dem Verbindungselement den Vorteil auf, dass die Montage eines solchen Messgeräts besonders einfach ist.

Das auf diese Weise hergestellte Messgerät ist vorzugsweise gemäß einer der zuvor beschriebenen Ausgestaltungen ausgestaltet.

Im Einzelnen gibt es nun eine Vielzahl von Möglichkeiten, das erfindungsgemäße Messgerät und das erfindungsgemäße Verfahren auszugestalten und weiterzubilden. Dazu wird verwiesen sowohl auf die den unabhängigen Patentansprüchen nachgeordneten Patentansprüche als auch auf die nachfolgende Beschreibung von bevorzugten Ausführungsbeispielen in Verbindung mit der Zeichnung. In der Zeichnung zeigen
- Fig. 1: ein erstes Ausführungsbeispiel eines Messgeräts,
- Fig. 2: ein erstes Ausführungsbeispiel einer ersten Elektronikeinrichtung,
- Fig. 3: das erste Ausführungsbeispiel einer ersten Elektronikeinrichtung in rückseitiger Ansicht,
- Fig. 4: das erste Ausführungsbeispiel der ersten Elektronikeinrichtung in anderer Ansicht,
- Fig. 5: ein zweites Ausführungsbeispiel einer ersten Elektronikeinrichtung,
- Fig. 6: ein drittes Ausführungsbeispiel einer ersten Elektronikeinrichtung in einem Transmittergehäuse,
- Fig. 7: ein viertes Ausführungsbeispiel einer ersten Elektronikeinrichtung in einem Transmittergehäuse,
- Fig. 8: ein erstes Ausführungsbeispiel einer zweiten Elektronikeinrichtung in einem Transmittergehäuse,
- Fig. 9: die Anschlusseinheit des ersten Ausführungsbeispiels der zweiten Elektronikeinrichtung,
- Fig. 10: ein Ausführungsbeispiel einer mehrlagigen zweiten Elektronikeinrichtung und
- Fig. 11: ein erstes Ausführungsbeispiel eines erfindungsgemäßen Verfahrens.

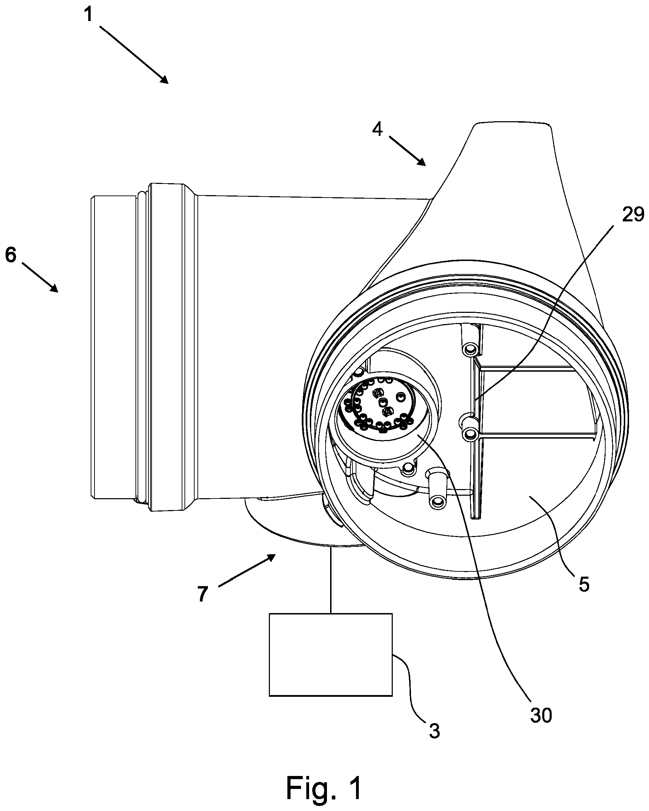

Fig. 1 zeigt eine Darstellung eines Messgeräts 1 mit einem Sensor 3 zur Aufnahme einer physikalischen Messgröße und mit einem Transmittergehäuse 4. Das Transmittergehäuse 4 umfasst einen Klemmenraum 5 und einen zum Klemmenraum 5 benachbarten und über eine Trennwand 29 verbundenen Elektronikraum 6, wobei in dem dargestellten Messgerät der Klemmenraum 5 leer ist bzw. keine Elektronikeinrichtung aufweist. Die Trennwand 29 weist eine Ausnehmung 30 zur Aufnahme einer Kontaktierungseinheit 12 auf. Zudem weist der Elektronikraum 6 einen Anschluss 7 zum Sensor 3 auf.

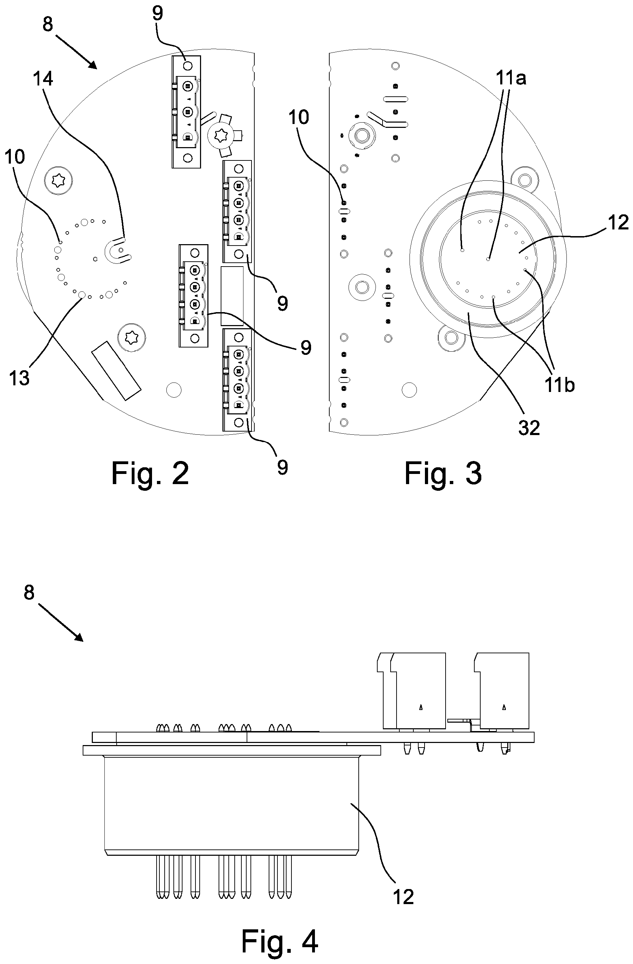

In Fig. 2 ist ein erstes Ausführungsbeispiel einer ersten Elektronikeinrichtung 8 in Form einer Leiterplatte, die im Betriebszustand im Klemmenraum 5 angeordnet ist, dargestellt. Die Leiterplatte ist halbkreisförmig ausgestaltet und ist in ihrer Form an die Form des inneren Querschnittes des Klemmenraums 5 angepasst. Auf der Leiterplatte sind Klemmen 9 für den Anschluss von Versorgungs- und I/O-Leitungen 33 angeordnet. Zudem sind Durchkontaktierungen 10 vorhanden, die mit den Kontaktelementen 11 der Kontaktierungseinheit 12, wie nachfolgend dargestellt, fest verbunden sind. Im dargestellten Ausführungsbeispiel sind die Kontaktelemente 11 mit den Durchkontaktierungen 10 verlötet. Insofern kann die Leiterplatte und die Kontaktierungseinheit 12 als Baugruppe gehandhabt werden und insbesondere als Einheit montiert und auch ausgetauscht werden. Zur Vergrößerung des Abstandes zwischen den Durchkontaktierungen 10 bzw. den Kontaktelementen 11 sind in der Leiterplatte kreisförmige Bohrungen 13 und ein gebogener Schlitz 14 vorhanden.

Fig. 3 zeigt die in Fig. 2 dargestellte Leiterplatte in rückseitiger Ansicht. Die Darstellung zeigt die Seite der Leiterplatte, die im Betriebszustand dem Elektronikraum 6 zugewandt ist. Neben den Durchkontaktierungen 10 für den Anschluss über die Klemmen 9 ist eine Kontaktierungseinheit 12 in Form eines elektrischen Durchführungselementes mit Kontaktelementen 11 in Form von Netzanschlusselementen 11a und Signalkontaktelementen 11b vorhanden. Die Signalkontaktelemente 11b sind derartig kreisförmig um die Netzanschlusselemente 11a angeordnet, dass der Abstand zwischen den Netzanschlusselementen 11a und den Signalkontaktelementen 11b dem normierten Mindestabstand zur Einhaltung der Luft- und Kriechfestigkeit entspricht. Die Anforderungen an den Abstand zwischen den Signalkontaktelementen 11b untereinander sind geringer. In dem dargestellten Ausführungsbeispiel sind auch die Abstände zwischen den Signalkontaktelementen 11b derart bemessen, dass die Leiterplatte für den Einsatz in explosionsgefährdeter Umgebung geeignet ist. Darüber hinaus weist das Durchführungselement einen Schutzkragen 32 auf, der die Zündschutzsicherheit erhöht.

In Fig. 4 ist das erste Ausführungsbeispiel der ersten Elektronikeinrichtung 8 in Seitenansicht dargestellt.

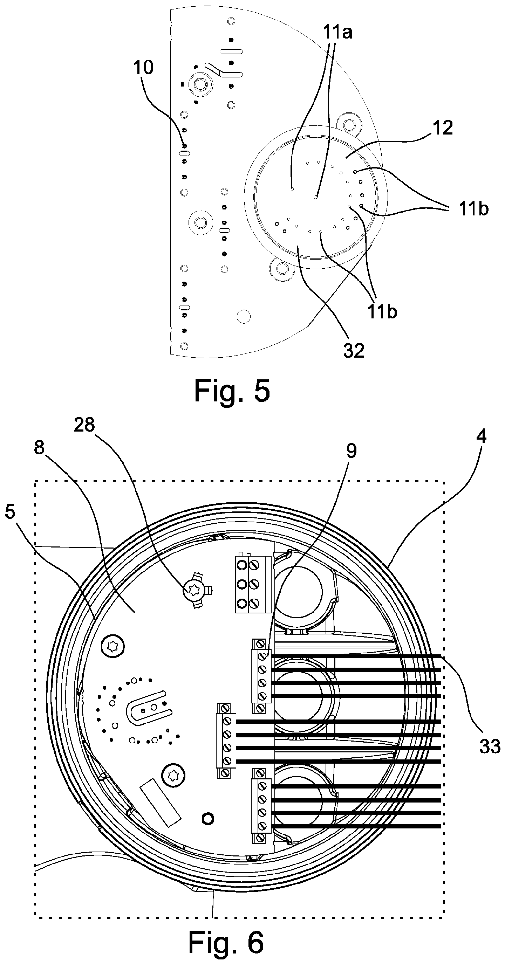

Die Fig. 5 zeigt ebenfalls eine im Klemmenraum 5 anzuordnende erste Elektronikeinrichtung 8 in Form einer Leiterplatte zusammen mit einer auf der Leiterplatte angeordneten und fest mit der Leiterplatte verbundenen Kontaktierungseinheit 12 in Form eines elektrischen Durchführungselementes. Die auf dem Durchführungselement angeordneten Signalkontaktelemente 11b sind in zwei Kreisen um die Netzanschlusselemente 11a angeordnet. Dabei entspricht der Abstand zwischen den auf dem inneren Kreis angeordneten Signalkontaktelementen 11b und den Netzanschlusselementen 11a dem erforderlichen Mindestabstand zur Gewährleistung einer Luft- und Kriechfestigkeit. Der Abstand der auf dem äußeren Kreis angeordneten Signalkontaktelementen 11b zu den auf dem inneren Kreis angeordneten Signalkontaktelementen 11b ist jedoch geringer als der erforderliche Mindestabstand, so dass sich die dargestellte Baueinheit lediglich für den Einsatz in einer nicht-explosionsgefährdeten Umgebung eignet. In vorteilhafter Weise weist das elektrische Durchführungselement besonders viele Signalkontaktelemente 11b zur Übertragung elektrische Signale auf.

In Fig. 6 ist eine in dem Klemmenraum 5 angeordnete erste Elektronikeinrichtung 8 in Form einer Leiterplatte dargestellt. Auf der Leiterplatte sind Klemmen 9 angeordnet, die mit I/O-Leitungen 33 verbunden sind. Zudem ist die Leiterplatte über eine Schraubverbindung mit dem Transmittergehäuse 4 verbunden. Weiterhin ist eine sichere Verbindung 28 vorhanden, die das Massepotential der Leiterplatte elektrisch leitend mit dem Transmittergehäuse 4 verbindet.

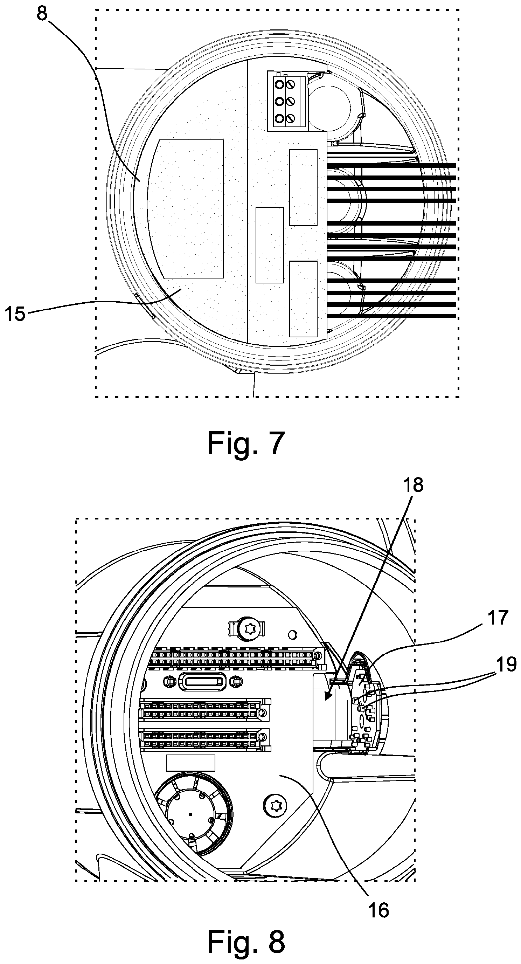

Die in Fig. 7 dargestellte erste Elektronikeinrichtung 8 in Form einer Leiterplatte ist ebenfalls in einem Klemmenraum 5 angeordnet. Zum Schutz des Anwenders sind die Leiterplatte und die Klemmen 9 mit einer isolierenden Abdeckung 15 versehen.

In Fig. 8 ist ein erstes Ausführungsbeispiel einer zweiten Elektronikeinrichtung 16 in Form einer Leiterplatte dargestellt. Die Leiterplatte ist im Elektronikraum 6 eines Transmittergehäuses 4 angeordnet. Die Leiterplatte ist als starrflexe Leiterplatte ausgestaltet, wobei zwei starre Leiterplattenteile über einen flexiblen Teil 18 miteinander verbunden sind. Die Leiterplatte umfasst weiterhin eine Anschlusseinheit 17 für die Verbindung mit dem in dem Klemmenraum 5 angeordneten elektrischen Durchführungselement. Die Anschlusseinheit 17 weist Verbindungselemente 19 in Form von Netzverbindungselementen 19a und Signalverbindungselementen 19b auf, wobei die Signalverbindungselemente 19b entsprechend den Signalkontaktelementen 11b, wie in Fig. 5 dargestellt, in zwei Kreisen um die Netzverbindungselemente 19a angeordnet sind.

Die Verbindungselemente 19 sind derart ausgestaltet, dass sie mit den Kontaktelementen 11 elektrisch leitend mittels einer Steckverbindung verbunden werden können. Die Verbindungselemente 19 sind dazu trichterförmig ausgestaltet. Die Anschlusseinheit 17 ist senkrecht zur Fügerichtung der Steckverbindung schwimmend in einer Halterung angeordnet und kann sich so bei der Verbindung mit den Kontaktelementen 11 an die Position des Durchführungselementes anpassen. Insgesamt ist die Verbindung zwischen den Verbindungselementen 19 und den Kontaktelementen 11 damit selbstzentrierend ausgestaltet.

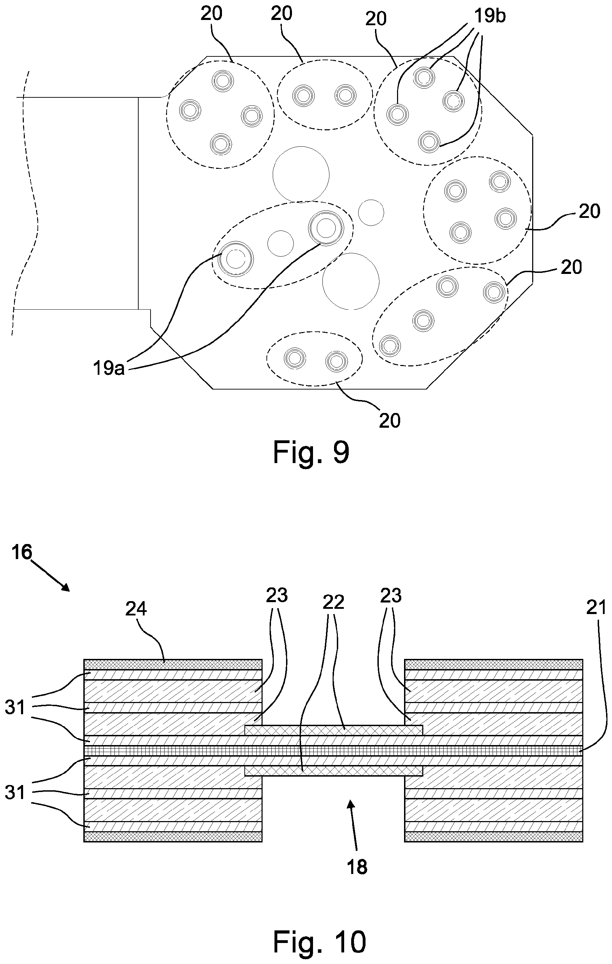

Fig. 9 zeigt die Anschlusseinheit 17 des ersten Ausführungsbeispiels der zweiten Elektronikeinrichtung 16. Die Anschlusseinheit 17 weist Netzverbindungselemente 19a und Signalverbindungselemente 19b auf, wobei die Signalverbindungselemente 19b kreisförmig in zwei Kreisen um die Netzverbindungselemente 19a angeordnet sind. Zudem sind die Signalverbindungselemente 19b zu Schaltkreisgruppen 20 gruppiert auf der Anschlusseinheit 17 angeordnet.

Fig. 10 zeigt den Aufbau einer Ausgestaltung der in dem Elektronikraum 6 angeordneten starrflexen Leiterplatte. Die Leiterplatte ist als Mehrlagenflexleiterplatte mit innenliegenden Leiterbahnen ausgestaltet. Im dargestellten Ausführungsbeispiel weisen die starren Leiterplattenteile jeweils sechs übereinander angeordnete Metalllisierungsschichten 31 auf. Der flexible Teil 18 der starrflexen Leiterplatte weist zwei Metallsierungsschichten auf, die jeweils mit Isolierstoff abgedeckt sind. Innenliegend ist eine Folie 21 aus Flex Polyimid mit einer Dicke von ca 50 µm angeordnet, durch die die flexible Teil 18 der Leiterplatte biegbar ist. Der flexible Teil 18 der starrflexen Leiterplatte 16 ist weiterhin durch eine Polyimid Schutzschicht 22, die eine Dicke zwischen 25 und 50 µm aufweist, bedeckt. Weiterhin weist die Leiterplatte Zwischenschichten 23 aus vorimprägnierten Faserwerkstoff auf, die jeweils eine Dicke zwischen 250 µm und 600 µm aufweisen. Der starre Teil der Leiterplatte 16 weist eine Lötabdeckung 24 auf.

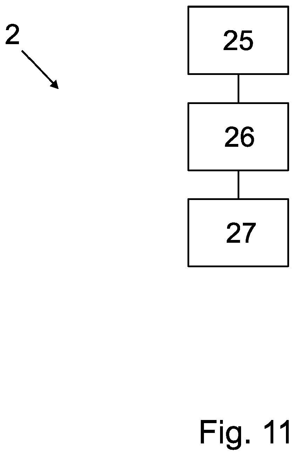

In Fig. 11 ist ein Verfahren 2 zur Herstellung eines Messgeräts 1 dargestellt, wobei das Messgerät 1 einen Sensor 3 und ein Transmittergehäuse 4 aufweist, wobei das Transmittergehäuse 4 einen Klemmenraum 5 und einen zum Klemmenraum 5 benachbarten und über eine Trennwand 29 verbundenen Elektronikraum 6 aufweist, wobei in dem Klemmenraum 5 eine erste Elektronikeinrichtung 8 für den Anschluss von Versorgungs- und I/O-Leitungen 33 angeordnet ist und wobei in dem Elektronikraum 6 eine zweite Elektronikeinrichtung 16 mit Elektronik zur Steuerung des Sensors 3 angeordnet ist, wobei die in dem Elektronikraum 6 angeordnete zweite Elektronikeinrichtung 16 eine Anschlusseinheit 17 aufweist,
wobei eine Kontaktierungseinheit 12 in Form eines elektrischen Durchführungselementes vorhanden ist, die mit der ersten Elektronikeinrichtung 8 fest verbunden ist,
wobei die Kontaktierungseinheit 12 Kontaktelemente 11 in Form von Netzanschlusselementen 11a und Signalkontaktelementen 11b zur Übertragung elektrischer Signale aufweist,
wobei die Anschlusseinheit 17 Verbindungselemente 19 in Form von Netzverbindungselementen 19a und Signalverbindungselementen 19b aufweist.

Das Verfahren 2 umfasst die folgenden Schritte:
- Montieren 25 der zweiten Elektronikeinrichtung 16 in dem Elektronikraum 6, wobei die Anschlusseinheit 17 schwimmend angeordnet wird,
- Montieren 26 der ersten Elektronikeinrichtung 8 in dem Klemmenraum 5, wobei die Kontaktierungseinheit 12 lösbar in die Trennwand eingesetzt wird,
- wobei durch das Montieren 26 der ersten Elektronikeinrichtung 8 die Kontaktierungseinheit 12 mit der Anschlusseinheit 17 verbunden wird,
- wobei die Anschlusseinheit 17 sich selbstzentrierend an die Position der Kontaktierungseinheit 12 anpasst 27.

Das dargestellte Verfahren weist den Vorteil auf, dass die Herstellung eines Messgeräts 1, insbesondere die Verbindung des elektrischen Durchführungselementes mit der Anschlusseinheit 17 besonders einfach ist, wodurch sowohl die Herstellung als auch ein Austauschen insbesondere der Baueinheit aus dem elektrischen Durchführungselement und der ersten Elektronikeinrichtung 8 besonders einfach ist.

### Bezugszeichen

- 1: Messgerät
- 2: Verfahren zur Herstellung eines Messgeräts
- 3: Sensor
- 4: Transmittergehäuse
- 5: Klemmenraum
- 6: Elektronikraum
- 7: Anschluss
- 8: Erste Elektronikeinrichtung
- 9: Klemme
- 10: Durchkontaktierung
- 11: Kontaktelemente
- 11a: Netzanschlusselemente
- 11b: Signalkontaktelemente
- 12: Kontaktierungseinheit
- 13: Bohrung
- 14: Schlitz
- 15: isolierende Abdeckung
- 16: zweite Elektronikeinrichtung
- 17: Anschlusseinheit
- 18: flexibler Teil
- 19: Verbindungselemente
- 19a: Netzverbindungselemente
- 19b: Signalverbindungselemente
- 20: Schaltkreisgruppe
- 21: Folie aus Flex Polyimid
- 22: Polyimid Schutzschicht
- 23: Schicht aus vorimpregnierten Fasern
- 24: Lötabdeckung
- 25: Montieren der zweiten Leiterplatte
- 26: Montieren der ersten Leiterplatte
- 27: Anpassen an die Position der Durchführung
- 28: sichere Verbindung
- 29: Trennwand
- 30: Ausnehmung
- 31: Metalllisierungsschicht
- 32: Schutzkragen
- 33: I/O-Leitung

## Patentansprüche

1. Messgerät (1) mit wenigstens einem Sensor (3) und mit wenigstens einem Transmittergehäuse (4), wobei das Transmittergehäuse (4) wenigstens einen Klemmenraum (5) und einen zum Klemmenraum (5) benachbarten und über eine Trennwand (29) verbundenen Elektronikraum (6) aufweist, wobei in dem Klemmenraum (5) wenigstens eine erste Elektronikeinrichtung (8) für den Anschluss von Versorgungs- und/oder I/O-Leitungen (33) angeordnet ist und wobei in dem Elektronikraum (6) wenigstens eine zweite Elektronikeinrichtung (16) mit Elektronik zur Steuerung des Sensors (3) angeordnet ist, wobei die erste Elektronikeinrichtung (8) und die zweite Elektronikeinrichtung (16) über eine Kontaktierungseinheit (12) miteinander elektrisch leitend verbunden sind, wobei die Kontaktierungseinheit (12) lösbar in eine Ausnehmung (30) der Trennwand (29) eingesetzt ist,
**dadurch gekennzeichnet,**
**dass** die Kontaktierungseinheit (12) mit der ersten Elektronikeinrichtung (8) fest verbunden ist, wobei die feste Verbindung eine unlösbare Verbindung ist, sodass die Kontaktierungseinheit und die Elektronikeinrichtung als ein Bauteil handhabbar sind,
**dass** die Kontaktierungseinheit (12) Kontaktelemente (11) in Form von Netzanschlusselementen (11a) und/oder Signalkontaktelementen (11b) zur Übertragung elektrischer Signale aufweist
**dass** die in dem Elektronikraum (6) angeordnete zweite Elektronikeinrichtung (16) eine Anschlusseinheit (17) aufweist,
**dass** die Anschlusseinheit (17) Verbindungselemente (19) in Form von Netzverbindungselementen (19a) und/oder Signalverbindungselementen (19b) aufweist, wobei die Verbindungselemente mit den Kontaktelementen elektrisch leitend mittels einer Steckverbindung verbunden sind.

2. Messgerät (1) nach Anspruch 1, **dadurch gekennzeichnet, dass** die Kontaktierungseinheit (12) als elektrisches Durchführungselement ausgestaltet ist, vorzugsweise als Stopfen mit eingeglasten oder in Kunststoff eingegossenen Kontaktelementen (11), insbesondere wobei der Stopfen in einen Metallzylinder eingefasst ist.

3. Messgerät (1) nach einem der vorigen Ansprüche, **dadurch gekennzeichnet, dass** die Netzanschlusselemente (11a) und/oder die Signalkontaktelemente (11b) zumindest teilweise stoffschlüssig mit der ersten Elektronikeinrichtung (8) verbunden sind.

4. Messgerät (1) nach einem der vorigen Ansprüche, **dadurch gekennzeichnet, dass** die erste Elektronikeinrichtung (8) mit den Kontaktelementen (11) der Kontaktierungseinheit (12) fest verbunden ist und dass die erste Elektronikeinrichtung (8) zwischen den Netzanschlusselementen (11a) und den Signalkontaktelementen (11b) und/oder zwischen den Signalkontaktelementen (11b) untereinander und/oder zwischen der Netzanschlusselementen (11a) untereinander Mittel zur Vergrößerung des Abstandes, beispielsweise wenigstens eine Bohrung (13) und/oder wenigstens einen Schlitz (14), aufweist.

5. Messgerät (1) nach einem der vorigen Ansprüche, **dadurch gekennzeichnet, dass** die Signalkontaktelemente (11b) kreisförmig in wenigstens einem Kreis um wenigstens ein Netzanschlusselement (11a) angeordnet sind.

6. Messgerät (1) nach einem der vorigen Ansprüche, **dadurch gekennzeichnet, dass** die Signalkontaktelemente (11b) derart, vorzugsweise kreisförmig, um das wenigstens eine Netzanschlusselement (11a) angeordnet sind, dass der Abstand zwischen dem wenigstens einen Netzanschlusselement (11a) und den Signalkontaktelementen (11b) mindestens dem normierten Mindestabstand zur Gewährleistung der Luft- und Kriechfestigkeit entspricht.

7. Messgerät (1) nach einem der Ansprüche 4 bis 6, **dadurch gekennzeichnet, dass** die Signalkontaktelemente (11b) zu wenigstens einer Schaltkreisgruppe (20) zusammengefasst sind, wobei die wenigstens eine Schaltkreisgruppe (20) wenigstens zwei Signalkontaktelemente (11b) aufweist.

8. Messgerät (1) nach Anspruch 7, **dadurch gekennzeichnet, dass** die Kontaktierungseinheit (12) derart ausgestaltet ist, dass innerhalb wenigstens einer Schaltkreisgruppe (20) oder zwischen wenigstens zwei Schaltkreisgruppen (20) wenigstens ein Abstand zwischen zwei Signalkontaktelementen (11b) den normierten Mindestabstand zur Einhaltung der Luft- und/oder Kriechfestigkeit unterschreitet.

9. Messgerät (1) nach Anspruch 1, **dadurch gekennzeichnet, dass** die Anschlusseinheit (17) schwimmend angeordnet ist und wobei die Verbindungselemente (19) und/oder die Kontaktelemente (11) derart ausgestaltet sind, dass die Verbindung zwischen den Verbindungselementen (19) und den Kontaktelementen (11) selbstzentrierend ist.

10. Messgerät (1) nach Anspruch 9, **dadurch gekennzeichnet, dass** die Verbindungselemente (19) und/oder die Kontaktelemente (11) als trichterförmige Aufnahmen ausgestaltet sind.

11. Transmittergehäuse (4), wobei das Transmittergehäuse (4) wenigstens einen Klemmenraum (5) und einen zum Klemmenraum (5) benachbarten und über eine Trennwand (29) verbundenen Elektronikraum (6) aufweist, wobei in dem Klemmenraum (5) wenigstens eine erste Elektronikeinrichtung (8) für den Anschluss von Versorgungs- und/oder I/O-Leitungen (33) angeordnet ist und wobei in dem Elektronikraum (6) wenigstens eine zweite Elektronikeinrichtung (16) mit Elektronik zur Steuerung des Sensors (3) angeordnet ist, wobei die erste Elektronikeinrichtung (8) und die zweite Elektronikeinrichtung (16) über eine Kontaktierungseinheit (12) miteinander elektrisch leitend verbunden sind, wobei die Kontaktierungseinheit (12) lösbar in eine Ausnehmung (30) der Trennwand (29) eingesetzt ist,
**dadurch gekennzeichnet,**
**dass** die Kontaktierungseinheit (12) mit der ersten Elektronikeinrichtung (8) fest verbunden ist, wobei die feste Verbindung eine unlösbare Verbindung ist, sodass die Kontaktierungseinheit und die Elektronikeinrichtung als ein Bauteil handhabbar sind,
wobei die Kontaktierungseinheit (12) Kontaktelemente (11) in Form von Netzanschlusselementen (11a) und/oder Signalkontaktelementen (11b) zur Übertragung elektrischer Signale aufweist
wobei die in dem Elektronikraum (6) angeordnete zweite Elektronikeinrichtung (16) eine Anschlusseinheit (17) aufweist,
wobei die Anschlusseinheit (17) Verbindungselemente (19) in Form von Netzverbindungselementen (19a) und/oder Signalverbindungselementen (19b) aufweist, wobei die Verbindungselemente mit den Kontaktelementen elektrisch leitend mittels einer Steckverbindung verbunden sind und
**dass** das Transmittergehäuse (4) für die Verwendung in einem Messgerät (1) gemäß einem der Patentansprüche 1 bis 10 ausgestaltet ist.

12. Verfahren (2) zur Herstellung eines Messgeräts (1), wobei das Messgerät (1) wenigstens einen Sensor (3) und wenigstens ein Transmittergehäuse (4) aufweist, wobei das Transmittergehäuse (4) wenigstens einen Klemmenraum (5) und einen zum Klemmenraum (5) benachbarten und über eine Trennwand verbundenen Elektronikraum (6) aufweist, wobei in dem Klemmenraum (5) eine erste Elektronikeinrichtung (8) für den Anschluss von Versorgungs- und/oder I/O-Leitungen (33) angeordnet ist und wobei in dem Elektronikraum (6) eine zweite Elektronikeinrichtung (16) mit Elektronik zur Steuerung des Sensors (3) angeordnet ist, wobei die in dem Elektronikraum (6) angeordnete zweite Elektronikeinrichtung (16) eine Anschlusseinheit (17) aufweist,
wobei eine Kontaktierungseinheit (12) vorhanden ist, die mit der ersten Elektronikeinrichtung (8) fest verbunden ist,
wobei die Kontaktierungseinheit (12) Kontaktelemente (11) in Form von Netzanschlusselementen (11a) und/oder Signalkontaktelementen (11b) zur Übertragung elektrischer Signale aufweist,
wobei die Anschlusseinheit (17) Verbindungselemente (19) in Form von Netzverbindungselementen (19a) und/oder Signalverbindungselementen (19b) aufweist, wobei die Verbindungselemente mit den Kontaktelementen elektrisch leitend mittels einer Steckverbindung verbunden werden, wobei die Steckverbindung eine Fügerichtung aufweist,
und wobei das Verfahren (2) die folgenden Schritte umfasst:
- Montieren (25) der zweiten Elektronikeinrichtung (16) in dem Elektronikraum (6), wobei die Anschlusseinheit (17) senkrecht zur Fügerichtung schwimmend angeordnet wird und wobei die Anschlusseinheit in Fügerichtung fest angeordnet wird,
- Montieren (26) der ersten Elektronikeinrichtung (8) in dem Klemmenraum (5), wobei die Kontaktierungseinheit (12) lösbar in die Trennwand eingesetzt wird,
- wobei durch das Montieren (26) der ersten Elektronikeinrichtung (8) die Kontaktierungseinheit (12) mit der Anschlusseinheit (17) verbunden wird,
- wobei die Anschlusseinheit (17) sich selbstzentrierend an die Position der Kontaktierungseinheit (12) anpasst (27).

## Claims

1. Measuring device (1) with at least one sensor (3) and with at least one transmitter housing (4), wherein the transmitter housing (4) has at least one terminal space (5) and an electronics space (6) adjacent to the terminal space (5) and connected via a partition wall (29), wherein at least a first electronic device (8) for the connection of supply and/or I/O lines (33) is arranged in the terminal space (5) and wherein at least a second electronic device (16) is arranged in the electronics space (6) with electronics for controlling the sensor (3), wherein the first electronic device (8) and the second electronic device (16) are electrically conductively connected to one another via a contacting unit (12), wherein the contacting unit (12) is removably inserted into a recess (30) of the partition wall (29),
**characterized in**
**that** the contacting unit (12) is firmly connected to the first electronic device (8), wherein the fixed connection is a non-detachable connection, so that the contacting unit and the electronic device can be handled as one component,
**that** the contacting unit (12) has contact elements (11) in the form of network contact elements (11a) and/or signal contact elements (11b) for transmitting electrical signals,
**that** the second electronic device (16) arranged in the electronics compartment (6) has a terminal unit (17),
**that** the terminal unit (17) has connecting elements (19) in the form of network connecting elements (19a) and/or signal connecting elements (19b), wherein the connecting elements are electrically conductively connected to the contact elements by means of a plug connection.

2. Measuring device (1) according to claim 1, **characterized in that** the contacting unit (12) is designed as an electrical feedthrough element, preferably as a plug with contact elements (11) that are glazed or cast in plastic, in particular wherein the plug is enclosed in a metal cylinder.

3. Measuring device (1) according to any one of the previous claims, **characterized in that** the network contact elements (11a) and/or the signal contact elements (11b) are at least partially substance bonded to the first electronic device (8).

4. Measuring device (1) according to any one of the previous claims, **characterized in that** the first electronic device (8) is fixedly connected with the contact elements (11) of the contacting unit (12) and that the first electronic device (8) has means for increasing the distance, for example at least one bore (13) and/or at least one slot (14) between the network contact elements (11a) and the signal contact elements (11b) and/or between the signal contact elements (11b) with one another and/or between the network contact elements (11a) with one another.

5. Measuring device (1) according to any one of the previous claims, **characterized in that** the signal contact elements (11b) are arranged circularly in at least one circle around at least one network contact element (11a).

6. Measuring device (1) according to any one of the previous claims, **characterized in that** the signal contact elements (11b) are arranged, preferably circular, around the at least one network contact element (11a) in such a manner that the distance between the at least one network contact element (11a) and the signal contact elements (11b) is in accordance with at least the normalized minimum distance to ensure air and creep resistance.

7. Measuring device (1) according to any one of claims 4 to 6, **characterized in that** the signal contact elements (11b) are combined to form at least one circuit group (20), wherein the at least one circuit group (20) has at least two signal contact elements (11b).

8. Measuring device (1) according to claim 7, **characterized in that** the contacting unit (12) is designed such that, within at least one circuit group (20) or between at least two circuit groups (20), at least one distance between two signal contact elements (11b) falls below the standardized minimum distance to comply with the air and/or creep resistance.

9. Measuring device (1) according to claim 1, **characterized in that** the terminal unit (17) is arranged to float and wherein the connecting elements (19) and/or the contact elements (11) are designed such that the connection between the connecting elements (19) and the contact elements (11) is self-centering.

10. Measuring device (1) according to claim 9, **characterized in that** the connecting elements (19) and / or the contact elements (11) are configured as funnel-shaped receptacles.

11. Transmitter housing (4), wherein the transmitter housing (4) has at least one terminal space (5) and an electronics space (6) adjacent to the terminal space (5) and connected via a partition wall (29), wherein at least one first electronic device (8) for the connection of supply and/or I/O lines (33) is arranged in the terminal space (5) and wherein at least a second electronic device (16) is arranged in the electronics space (6) with electronics for controlling the sensor (3) wherein the first electronic device (8) and the second electronic device (16) are electrically conductively connected to one another via a contacting unit (12), wherein the contacting unit (12) is removably inserted into a recess (30) of the partition wall (29),
**characterized in**
**that** the contacting unit (12) is fixedly connected to the first electronic device (8), wherein the fixed connection is a non-detachable connection, so that the contacting unit and the electronic device can be handled as one component,
wherein the contacting unit (12) has contact elements (11) in the form of network contact elements (11a) and/or signal contact elements (11b) for transmitting electrical signals,
wherein the second electronic device (16) arranged in the electronics compartment (6) has a terminal unit (17),
wherein the terminal unit (17) has connecting elements (19) in the form of network connecting elements (19a) and/or signal connecting elements (19b), wherein the connecting elements are electrically conductively connected to the contact elements by means of a plug connection and
in that the transmitter housing (4) is designed for use in a measuring device (1) according to any one of claims 1 to 10.

12. Method (2) for producing a measuring device (1), wherein the measuring device (1) has at least one sensor (3) and at least one transmitter housing (4), wherein the transmitter housing (4) has at least one terminal space (5) and an electronics space (6) adjacent to the terminal space (5) and connected via a partition wall (29), wherein a first electronic device (8) for the connection of supply and/or I/O lines (33) is arranged in the terminal space (5) and a second electronic device (16) with electronics for controlling the sensor (3) is arranged in the electronics space (6), wherein the second electronic device (16) arranged in the electronics space (6) has a terminal unit (17),
wherein a contacting unit (12) is provided, which is fixedly connected to the first electronic device (8),
wherein the contacting unit (12) has contact elements (11) in the form of network contact elements (11a) and/or signal contact elements (11b) for transmitting electrical signals,
wherein the terminal unit (17) has connecting elements (19) in the form of network connecting elements (19a) and/or signal connecting elements (19b),
wherein the connecting elements are electrically conductively connected to the contact elements by means of a plug connection, wherein the plug connection has a joining direction
and wherein the method (2) comprises the following steps:
- installing (25) the second electronic device (16) in the electronics space (6), wherein the terminal unit (17) is arranged to float perpendicular to the joining direction and wherein the terminal unit is fixedly arranged in the joining direction,
- installing (26) the first electronic device (8) in the terminal space (5), wherein the contacting unit (12) is removably inserted into the partition wall,
- wherein the contacting unit (12) is connected to the terminal unit (17) due to the installation (26) of the first electronic device (8),
- wherein the terminal unit (17) adapts by self-centering to the position of the contacting unit (12).

## Revendications

1. Appareil de mesure (1) comprenant au moins un capteur (3) et au moins un boîtier d'émetteur (4), le boîtier d'émetteur (4) présentant au moins un compartiment à bornes (5) et un compartiment électronique (6) adjacent au compartiment à bornes (5) et relié par une cloison (29), au moins un premier dispositif électronique (8) pour le raccordement de lignes d'alimentation et/ou d'E/S (33) étant disposé dans le compartiment à bornes (5), et au moins un deuxième dispositif électronique (16) doté d'une électronique pour commander le capteur (3) étant disposé dans le compartiment électronique (6), le premier dispositif électronique (8) et le deuxième dispositif électronique (16) étant reliés l'un à l'autre de manière électriquement conductrice par une unité de mise en contact (12), l'unité de mise en contact (12) étant insérée de manière amovible dans un creux (30) de la cloison (29),
**caractérisé**
**en ce que** l'unité de mise en contact (12) est reliée solidement au premier dispositif électronique (8), la liaison solide étant une liaison inamovible de sorte que l'unité de mise en contact et le dispositif électronique peuvent être manipulés comme un seul composant,
**en ce que** l'unité de mise en contact (12) présente des éléments de contact (11) sous la forme d'éléments de raccordement au réseau (11a) et/ou d'éléments de contact de signal (11b) pour transmettre des signaux électriques,
**en ce que** le deuxième dispositif électronique (16) disposé dans le compartiment électronique (6) présente une unité de raccordement (17),
**en ce que** l'unité de raccordement (17) présente des éléments de liaison (19) sous la forme d'éléments de liaison au réseau (19a) et/ou d'éléments de liaison de signal (19b), les éléments de liaison étant reliés de manière électriquement conductrice aux éléments de contact au moyen d'une fiche de liaison.

2. Appareil de mesure (1) selon la revendication 1, **caractérisé en ce que** l'unité de mise en contact (12) est configurée sous la forme d'un élément de passage électrique, de préférence sous la forme d'un bouchon doté d'éléments de contact (11) vitrifiés ou moulés dans une matière plastique, le bouchon étant en particulier entouré d'un cylindre métallique.

3. Appareil de mesure (1) selon l'une quelconque des revendications précédentes, **caractérisé en ce que** les éléments de raccordement au réseau (11a) et/ou les éléments de contact de signal (11b) sont reliés au moins en partie par liaison de matière au premier dispositif électronique (8).

4. Appareil de mesure (1) selon l'une quelconque des revendications précédentes, **caractérisé en ce que** le premier dispositif électronique (8) est relié solidement aux éléments de contact (11) de l'unité de mise en contact (12), et **en ce que** le premier dispositif électronique (8) présente entre les éléments de raccordement au réseau (11a) et les éléments de contact de signal (11b) et/ou entre les éléments de contact de signal (11b) entre eux et/ou entre les éléments de raccordement au réseau (11a) entre eux des moyens pour augmenter la distance, par exemple au moins un alésage (13) et/ou au moins une fente (14).

5. Appareil de mesure (1) selon l'une quelconque des revendications précédentes, **caractérisé en ce que** les éléments de contact de signal (11b) sont disposés de manière circulaire dans au moins un cercle autour d'au moins un élément de raccordement au réseau (11a).

6. Appareil de mesure (1) selon l'une quelconque des revendications précédentes, **caractérisé en ce que** les éléments de contact de signal (11b) sont disposés, de préférence de manière circulaire, autour de l'au moins un élément de raccordement au réseau (11a) de telle sorte que la distance entre ledit au moins un élément de raccordement au réseau (11a) et les éléments de contact de signal (11b) correspond au moins à la distance minimale normalisée pour garantir la résistance à l'entrefer et au fluage.

7. Appareil de mesure (1) selon l'une quelconque des revendications 4 à 6, **caractérisé en ce que** les éléments de contact de signal (11b) sont regroupés en au moins un groupe de circuits (20), ledit au moins un groupe de circuits (20) présentant au moins deux éléments de contact de signal (11b).

8. Appareil de mesure (1) selon la revendication 7, **caractérisé en ce que** l'unité de mise en contact (12) est configurée de telle sorte qu'à l'intérieur d'au moins un groupe de circuits (20) ou entre au moins deux groupes de circuits (20), au moins une distance entre deux éléments de contact de signal (11b) soupasse la distance minimale normalisée pour respecter la résistance à l'entrefer et/ou au fluage.

9. Appareil de mesure (1) selon la revendication 1, **caractérisé en ce que** l'unité de raccordement (17) est disposée flottante, et les éléments de liaison (19) et/ou les éléments de contact (11) étant configurés de telle sorte que la liaison entre les éléments de liaison (19) et les éléments de contact (11) est à centrage automatique.

10. Appareil de mesure (1) selon la revendication 9, **caractérisé en ce que** les éléments de liaison (19) et/ou les éléments de contact (11) sont configurés comme des logements en forme d'entonnoirs.

11. Boîtier d'émetteur (4), dans lequel le boîtier d'émetteur (4) présente au moins un compartiment à bornes (5) et un compartiment électronique (6) adjacent au compartiment à bornes (5) et relié par une cloison (29), au moins un premier dispositif électronique (8) pour le raccordement de lignes d'alimentation et/ou d'E/S (33) étant disposé dans le compartiment à bornes (5), et au moins un deuxième dispositif électronique (16) doté d'une électronique pour commander le capteur (3) étant disposé dans le compartiment électronique (6), le premier dispositif électronique (8) et le deuxième dispositif électronique (16) étant reliés l'un à l'autre de manière électriquement conductrice par une unité de mise en contact (12), l'unité de mise en contact (12) étant insérée de manière amovible dans un creux (30) de la cloison (29),
**caractérisé**
**en ce que** l'unité de mise en contact (12) est reliée solidement au premier dispositif électronique (8), la liaison solide étant une liaison inamovible de sorte que l'unité de mise en contact et le dispositif électronique peuvent être manipulés comme un seul composant,
l'unité de mise en contact (12) présentant des éléments de contact (11) sous la forme d'éléments de raccordement au réseau (11a) et/ou d'éléments de contact de signal (11b) pour transmettre des signaux électriques,
le deuxième dispositif électronique (16) disposé dans le compartiment électronique (6) présentant une unité de raccordement (17),
l'unité de raccordement (17) présentant des éléments de liaison (19) sous la forme d'éléments de liaison au réseau (19a) et/ou d'éléments de liaison de signal (19b), les éléments de liaison étant reliés de manière électriquement conductrice aux éléments de contact au moyen d'une fiche de liaison, et
**en ce que** le boîtier d'émetteur (4) est configuré pour l'utilisation dans un appareil de mesure (1) selon l'une quelconque des revendications 1 à 10.

12. Procédé (2) de fabrication d'un appareil de mesure (1), l'appareil de mesure (1) présentant au moins un capteur (3) et au moins un boîtier d'émetteur (4), le boîtier d'émetteur (4) présentant au moins un compartiment à bornes (5) et un compartiment électronique (6) adjacent au compartiment à bornes (5) et relié par une cloison, un premier dispositif électronique (8) pour le raccordement de lignes d'alimentation et/ou d'E/S (33) étant disposé dans le compartiment à bornes (5), et un deuxième dispositif électronique (16) doté d'une électronique pour commander le capteur (3) étant disposé dans le compartiment électronique (6), le deuxième dispositif électronique (16) disposé dans le compartiment électronique (6) présentant une unité de raccordement (17) ,
une unité de mise en contact (12) étant présente qui est reliée solidement au premier dispositif électronique (8),
l'unité de mise en contact (12) présentant des éléments de contact (11) sous la forme d'éléments de raccordement au réseau (11a) et/ou d'éléments de contact de signal (11b) pour transmettre des signaux électriques,
l'unité de raccordement (17) présentant des éléments de liaison (19) sous la forme d'éléments de liaison au réseau (19a) et/ou d'éléments de liaison de signal (19b), les éléments de liaison étant reliés de manière électriquement conductrice aux éléments de contact au moyen d'une fiche de liaison, la fiche de liaison présentant une direction d'assemblage,
et le procédé (2) comprenant les étapes suivantes consistant à :
- monter (25) le deuxième dispositif électronique (16) dans le compartiment électronique (6), l'unité de raccordement (17) étant disposée flottante perpendiculairement à la direction d'assemblage, et l'unité de raccordement étant disposée solidement dans la direction d'assemblage,
- monter (26) le premier dispositif électronique (8) dans le compartiment à bornes (5), l'unité de mise en contact (12) étant insérée de manière amovible dans la cloison,
- le montage (26) du premier dispositif électronique (8) reliant l'unité de mise en contact (12) à l'unité de raccordement (17),
- l'unité de raccordement (17) s'adaptant (27) par centrage automatique à la position de l'unité de mise en contact (12).
